# EUROPÄISCHE PATENTANMELDUNG

(11) **EP 0 532 868 A1**
(43) Veröffentlichungstag der Anmeldung: **24.03.1993**
(21) Anmeldenummer: 92112915.1
(22) Anmeldetag: 29.07.1992
(51) Int. Cl.: H03F 3/30

(54) **Gegengekoppelter, stromeingeprägter Gegentaktverstärker zur Übertragung breitbandiger Wechselstromsignale**

(30) Priorität: 14.09.1991 DE 4130642
(71) Anmelder: Nokia (Deutschland) GmbH, D-75175 Pforzheim (DE)
(72) Erfinder: Reime, Gerd, W-7542 Schömberg 4 (DE)

(57) **Zusammenfassung**

Ein gegengekoppelter, stromeingeprägter Gegentaktverstärker zur Übertragung breitbandiger Wechselstromsignale enthält eine aus zwei komplementären Transistoren (6 und 7) gebildete Reihenschaltung (8), in der die Kollektoren der beiden Transistoren unmittelbar zusammengeschaltet sind und den Signalausgang (16) des Verstärkers bilden. Die Emitter (E6 und E7) der beiden Transistoren sind unmittelbar mit den Polen (9 und 10) einer Stromversorgung (11) verbunden. Die Basen (B6 und B7) der beiden Transistoren sind wechselstrommäßig unmittelbar mit dem Signaleingang (5) des Verstärkers verbunden und über Gegenkopplungs- und Bestromungswiderstände (13) mit dem Mittenanzapf (12) der Reihenschaltung verbunden, der gleichzeitig der Signalausgang (16) des Verstärkers (1) ist. Außerdem enthält der Verstärker zwischen seinem Signalausgang und seinem Signaleingang einen ohmschen Widerstand (15) als Wechselstrom-Gegenkopplung. Durch diese Maßnahmen erhält der Verstärker einen sehr niederohmigen Eingangswiderstand von wenigen Ohm, einen verhältnismäßig niedrigen Ausgangswiderstand für die zu übertragenden Wechselstromsignale, eine hohe Bandbreite und eine Aussteuerungsmöglichkeit der zu übertragenden Signale bis nahe an den Spannungswert (Ub) der Betriebsspannung der Stromversorgung.

## Beschreibung

Die Erfindung bezieht sich auf einen gegengekoppelten, stromeingeprägten Gegentaktverstärker der im Oberbegriff des Anspruches 1 angegebenen Art.

Ein derartiger Verstärker zur Übertragung von Tonsignalen ist aus der DE-Fachzeitschrift "Funkschau" 1969, Heft 8, Seite 226, bekannt. Er enthält in einer Reihenschaltung zwei komplimentäre Transistoren, die mit ihren Kollektoren unmittelbar an eine Stromquelle angeschlossen sind. Dieser Gegentaktendstufe ist eine Vorstufe aus einer Transistorkaskade vorgeschaltet, deren Eingang über eine Stromeinprägung gesteuert wird. Dadurch und durch eine starke Gleichstromgegenkopplung zwischen dem Mittenanzapf der Reihenschaltung der komplimentären Endstufentransistoren und der Transistorkaskade soll eine gute Mittelspannungskonstanz für die Endstufe auch bei Änderung der Betriebsspannung erreicht werden.

Im hochfrequenten Signalweg insbesondere von Fernsehgeräten oder Videorecordern, in dem breitbandig Videosignale mit Videofrequenzen weit über 5 MHz hinaus übertragen werden sollen, befinden sich zur Anpassung an bestimmte Übertragungsverfahren einer genormten Übertragung einer Videosendung und zur Einschränkung von Übertragungsstörungen Filter- und Anpassungsschaltungen. Derartige Schaltungen, insbesondere sogenannte Saugfilter erfordern einen nachgeschalteten Verstärker mit einem sehr geringen Eingangswiderstand für eine Stromeinprägung am Signaleingang des Verstärkers.

Der Erfindung liegt deshalb die Aufgabe zugrunde, für eine Stromeinprägung einen Signalverstärker bereitzustellen, der für die Stromeinprägung einen sehr kleinen Eingangswiderstand aufweist und bis in hohe Frequenzen hinauf (10 MHZ) breitbandig ist. Diese Aufgabe wird nach der Erfindung für einen eingangs angegebenen Verstärker mit den Merkmalen des kennzeichnenden Teils des Anspruches 1 gelöst.

Die Lösung der genannte Aufgabe erfolgt nach der Erfindung mit überraschend einfachen Mitteln, die eine Integration eines erfindungsgemäßen Verstärkers zulassen. Der Eingangswiderstand eines derartigen Verstärkers beträgt nur wenige Ohm. Der erfindungsgemäße Verstärker kann derart bemessen werden, daß er bei einer kleinen Versorgungsspannung an einem verhältnismäßig kleinem Ausgangswiderstand eine hohe Ausgangsspannung erzeugt, die einer Aussteuerung nahezu des vollen Spannungsbetrages der Versorgungsspannung entspricht, insbesondere dann, wenn die Kollektoren der beiden komplementären Transistoren unmittelbar miteinander verbunden sind. Sind darüber hinaus in einer weiteren vorteilhaften Ausbildung der Erfindung die beiden Gegentakthälften des Verstärkers elektrisch symetrisch zueinander bemessen, wird ein linearer Frequenzverlauf des Verstärkers bis in den Bereich der Frequenzgrenze der komplementären Transistoren des Verstärkers erzielt.

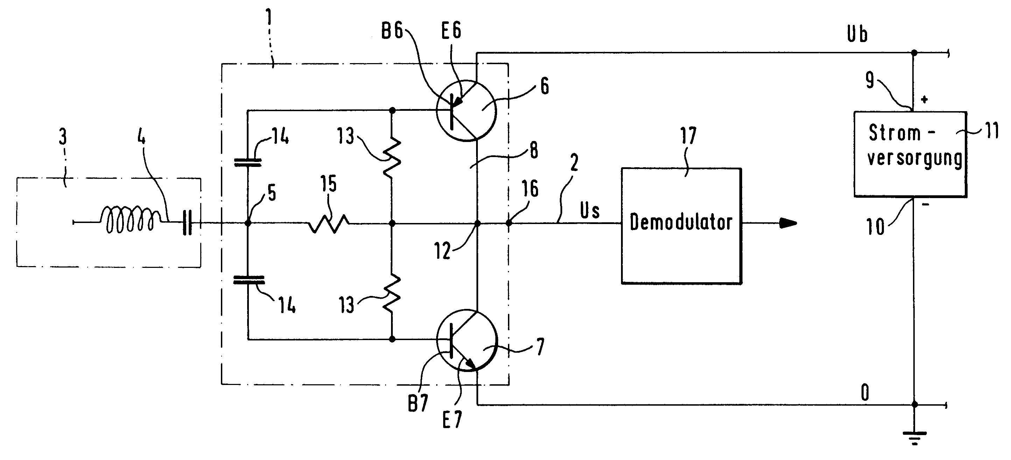

Die Erfindung wird nachfolgend anhand eines vorteilhaften Ausführungsbeispieles, das in der Zeichnung dargestellt ist, näher erläutert.

Die einzige Figur der Zeichnung zeigt das Prinzipschaltbild eines gegengekoppelten, stromeingeprägten Gegentaktverstärkers 1 zur Übertragung eines breitbandigen Videosignales auf einem Signalweg 2. Dem Gegentaktverstärker 1 ist im dargestellten Ausführungsbeispiel eine Filterschaltung 3 vorgeschaltet. Diese enthält ausgangsseitig einen Saugkreis 4, dessen Ausgang in einer Stromeinprägung an den Signaleingang 5 des Gegentaktverstärkers 1 angeschlossen ist. Um den Saugkreis 4 wenig zu bedämpfen, ist der Gegentaktverstärker 1 so ausgebildet, daß er am Signaleingang 5 dem Saugkreis 4 einen nur geringen Eingangswiderstand von wenigen Ohm entgegenstellt, so daß der Ausgangsstrom des Saugfilters 4 durch den nachgeschalteten Gegentaktverstärker 1 nur geringfügig bedämpft wird. Dieser niederohmige Eingangswiderstand wird dadurch erreicht, daß zwei komplementäre Transistoren 6 und 7 an ihren Kollektoren zu einer Reihenschaltung 8 zusammengeschlossen sind und mit ihren Emittern E6 und E7 unmittelbar mit den Polen 9 und 10 einer Stromversorgung 11 verbunden sind. Im dargestellten Ausführungsbeispiel ist der Pol 9 der Pluspol der Stromversorgung und der Pol 10 der mit dem Nullpotential der den Signalweg 2 enthaltenden Schaltung verbundene Minuspol der Stromversorgung.

Zwischen die Basen B6 und B7 der beiden komplementären Transistoren 6 und 7 und den Mittenanzapf 12 der aus den beiden komplementären Transistoren 6 und 7 gebildeten Reihen- oder Gegentaktschaltung 8 ist je ein ohmscher Widerstand 13 geschaltet, der sowohl die Gleichstromversorgung der Basis der beiden Transistoren 6 und 7 bildet als auch ein Gleichstrom-Gegenkopplungsglied darstellt. Die Bemessung dieser ohmschen Widerstände 13 bestimmt gleichzeitig den Arbeitspunkt der komplementären Transistoren 6 und 7. Die Basen B6 und B7 der beiden komplementären Transistoren 6 und 7 sind über Entkopplungskondensatoren 14 unmittelbar mit dem Signaleingang 5 des Verstärkers verbunden. Dadurch und durch ein Wechselstrom-Gegenkopplungsglied 15 zwischen dem Signaleingang 5 des Verstärkers 1 und dem Mittenanzapf 12 der Reihenschaltung 8 der komplementären Transistoren 6 und 7 wird der niederohmige Eingangswiderstand am Signaleingang 5 des Gegentaktverstärkers 1 hergestellt. Das Wechselstrom-Gegenkopplungsglied 15 ist ebenfalls als ohmscher Widerstand mit geringerem Widerstandswert als der der Gleichstrom-Gegenkopplungswiderstände 13 ausgebildet. Hierdurch wird eine Linearität des Frequenzganges des Gegentaktverstärkers 1 bis in den Bereich der Grenzfrequenz der komplementären Transistoren 6 und 7 erreicht. An den Signalausgang 16 des Verstärkers 1, der gleichzeitig der Mittenanzapf 12 der Reihenschaltung der komplementären Transistoren 6 und 7 ist, ist im dargestellten Ausführungsbeispiel ein Demodulator 17 zur Weiterverarbeitung des von dem Gegentaktverstärker 1 übertragenen Signals angeschlossen. Der Ausgangswiderstand des Signalausganges 16 wird von der Bemessung des Widerstandes 15 des Wechselstrom-Gegenkopplungsgliedes bestimmt und hat ebenfalls einen verhältnismäßig niedrigen Wert, der einige hundert Ohm betragen kann und der leicht an die Erfordernisse der nachgeschalteten Schaltung 17 angepaßt werden kann.

Da die aus den komplementären Transistoren 6 und 7 gebildete Reihenschaltung 8 keine strombegrenzenden Widerstände enthält, kann die Signalspannung Us am Ausgang 16 des Gegentaktverstärkers 1 so weit linear ausgesteuert werden, daß der Spitze-zu-Spitzenwert der Signalspannung Us nur geringfügig unterhalb dem Wert Ub der Betriebsspannung der Stromversorgung 11 liegt.

## Patentansprüche

1. Gegengekoppelter, stromeingeprägter Gegentaktverstärker zur Übertragung breitbandiger Wechselstromsignale mit einer unmittelbar zwischen den Polen einer Stromversorgung angeordneten Reihenschaltung zweier komplementärer Transistoren und einem Signalausgang (16) am Mittenanzapf (12) der Reihenschaltung (8),
**dadurch gekennzeichnet,**
- daß die Emitter (E6, E7) der an den Kollektoren zur Reihenschaltung (8) zusammengeschalteten beiden komplementären Transistoren (6, 7) unmittelbar mit den beiden Polen (9, 10) der Stromversorgung (11) verbunden sind,
- daß zwischen dem Mittenanzapf der Reihenschaltung und der Basis (B6, B7) der beiden komplementären Transistoren je ein Gleichstrom-Gegenkopplungsglied (13) angeordnet ist,
- daß die Basen der beiden komplementären Transistoren wechselstrommäßig unmittelbar mit dem Signaleingang (5) des Verstärkers (1) verbunden sind und
- daß der Signalausgang (16) des Verstärkers über ein lineares Wechselstrom-Gegenkopplungsglied (15) wechselstrommäßig mit dem Signaleingang (5) des Verstärkers verbunden ist.

2. Verstärker nach Anspruch 1,
**dadurch gekennzeichnet**, daß die Kollektoren der beiden komplementären Transistoren (6, 7) unmittelbar miteinander verbunden sind.

3. Verstärker nach Anspruch 1 oder 2,
**dadurch gekennzeichnet**, daß die beiden Gegentakthälften des Gegentaktverstärkers (1) elektrisch symetrisch zueinander bemessen sind.
